# EUROPEAN PATENT SPECIFICATION

(11) **EP 4 475 172 B1**
(45) Date of publication and mention of the grant of the patent: **05.11.2025**
(21) Application number: 24179665.5
(22) Date of filing: 03.06.2024
(51) Int. Cl.: H01L 21/768, H01L 23/522

(54) **ISOLATION STRUCTURE**
ISOLATIONSSTRUKTUR
STRUCTURE D'ISOLATION

(30) Priority: 06.06.2023 US 202318329847
(43) Date of publication of application: 11.12.2024
(73) Proprietor: NXP B.V., 5656 AG Eindhoven (NL)
(72) Inventor: Southworth, Paul, 5656AG Eindhoven (NL); van Soestbergen, Michiel, 5656AG Eindhoven (NL); Mavinkurve, Amar Ashok, 565AG Eindhoven (NL); Chuang, Wen Yuan, 5656AG Eindhoven (NL); Vincent, Michael B, 5656AG Eindhoven (NL)
(74) Representative: Krott, Michel

(56) References cited:
- US-A1- 2021 280 533
- US-A1- 2022 084 934
- US-A1- 2023 032 620

## Description

### TECHNICAL FIELD

Embodiments of the subject matter described herein relate generally to capacitive Galvanic isolation structures.

### BACKGROUND

Semiconductor devices find application in a wide variety of electronic components and systems. Such semiconductor devices commonly include integrated capacitors to block direct current (DC) voltages, attenuate low-frequency signals, or perform other applicable functions. Some semiconductor devices include multiple voltage domains, often requiring Galvanic isolation for signaling between voltage domains with sufficiently high voltage differentials between them. Galvanic isolation can be achieved through capacitive coupling using isolation structures such as integrated capacitors. However, dielectric breakdown can occur between electrically conductive elements of two given voltage domains with a sufficiently high voltage differential, resulting in undesirable flow of electric current. Such dielectric breakdown can undesirably damage corresponding dielectric layer(s) of the semiconductor device, potentially hindering the functionality thereof.

The patent publication US 2023/032620 A1 discloses a non-planar MIM capacitor including air gaps under edge regions of alternating plates, wherein the air gaps serve to isolate the plates from adjacent vertical interconnects.

### SUMMARY

A brief summary of various exemplary embodiments is presented below. Some simplifications and omissions may be made in the following summary, which is intended to highlight and introduce some aspects of the various exemplary embodiments, without limiting the scope. Detailed descriptions of an exemplary embodiment adequate to allow those of ordinary skill in the art to make and use these concepts will follow in later sections.

In an example embodiment, a semiconductor device is provided, as defined in claim 1.

In one or more embodiments, the semiconductor device further includes a third conductive structure disposed directly on the semiconductor substrate, a fourth conductive structure disposed at least partially on the first dielectric layer, and a conductive via that extends through the first dielectric layer between the first conductive structure and the third conductive structure, such that the conductive via electrically connects the fourth conductive structure to the third conductive structure. The fourth conductive structure and the first conductive structure are formed in the same layer.

In one or more embodiments, the semiconductor device further includes a second dielectric layer disposed over the first conductive structure and the first dielectric layer.

In one or more embodiments, the second dielectric layer includes an opening that overlaps the first conductive structure, such that an upper surface of the first conductive structure is exposed through the opening.

In one or more embodiments, the one or more air gaps in the first dielectric layer are disposed directly between edges of the lower surface of the first conductive structure and the semiconductor substrate, such that the one or more air gaps overlap a perimeter of the lower surface of the first conductive structure.

In one or more embodiments, the one or more air gaps in the first dielectric layer are disposed only at the corners of the lower surface of the first conductive structure.

In one or more embodiments, the semiconductor device further includes oxide material disposed on one or more surfaces of the first conductive structure at the corners of the first conductive structure, such that the oxide material separates the corners of the first conductive structure from the one or more air gaps in the first dielectric layer.

In one or more embodiments, the semiconductor device further includes a second dielectric layer disposed over the first dielectric layer and the first conductive structure, the second dielectric layer including at least one opening through which an upper surface of the first conductive structure is exposed.

In an example embodiment, a method for fabricating a semiconductor device is conceived, as defined in claim 9.

In one or more embodiments, etching the portions of the first dielectric layer through the openings in the patterned photoresist layer to form air gaps at the edges of the second capacitor plate includes etching the portions of the first dielectric layer through the openings in the patterned photoresist layer to form air gaps at the edges of the second capacitor plate.

In one or more embodiments, the first patterned conductive layer further includes a first conductive structure, and the second patterned conductive layer further includes a second conductive structure and a conductive via that electrically couples the first conductive structure to the second conductive structure.

In one or more embodiments, the method further includes performing a patterned etch of the first dielectric layer to form an opening in the first dielectric layer. The conductive via is subsequently formed in the opening in the first dielectric layer.

In one or more embodiments, the method further includes after forming the air gaps at the edges of the second capacitor plate, etching exposed portions of the second capacitor plate.

In one or more embodiments, etching the exposed portions of the second capacitor plate causes edges and corners of the second capacitor plate to be rounded.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1 is a cross-sectional side view of a semiconductor device having an isolation structure that includes an integrated capacitor with air gaps formed at edges or corners of an upper capacitor plate, in accordance with various embodiments.
FIG. 2 is a partially transparent top view of a semiconductor device, such as the semiconductor device of FIG. 1, in which air gaps are formed at corners of upper capacitor plates of integrated capacitors of the semiconductor device, in accordance with various embodiments.
FIG. 3 is a partially transparent top view of a semiconductor device, such as the semiconductor device of FIG. 1, in which air gaps are formed at edges of upper capacitor plates of integrated capacitors of the semiconductor device, in accordance with various embodiments.
FIG. 4 is a process flow diagram describing a method for fabricating the semiconductor device of FIG. 1, in accordance with various embodiments.
FIGS.5-15 are cross-sectional views depicting the semiconductor device of FIG. 1 at various stages of fabrication, in accordance with various embodiments.
FIG. 16 is a cross-sectional side view of a semiconductor device having an isolation structure that includes an integrated capacitor with air gaps formed at edges or corners of an upper capacitor plate, where such edges or corners are rounded and coated with a thin dielectric layer, in accordance with various embodiments.
FIG. 17 is a process flow diagram describing a method for fabricating the semiconductor device of FIG. 16, in accordance with various embodiments.
FIGS. 18 and 19 are cross-sectional views depicting the semiconductor device of FIG. 16 at various stages of fabrication, in accordance with various embodiments.

### DETAILED DESCRIPTION

The following detailed description is merely illustrative in nature and is not intended to limit the embodiments of the subject matter or the application and uses of such embodiments. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose. As used herein, the words "exemplary" and "example" mean "serving as an example, instance, or illustration." Any implementation described herein as exemplary or an example is not necessarily to be construed as preferred or advantageous over other implementations. The term "conductive," as used herein, is defined as at least electrically conductive (e.g., having an electrical resistivity on the order of around 10⁻⁸ Ω-cm to around 10⁻⁴ Ω-cm at standard temperature and pressure), unless indicated otherwise.

Directional references such as "top," "bottom," "left," "right," "above," "below," and so forth, unless otherwise stated, are not intended to require any preferred orientation and are made with reference to the orientation of the corresponding figure or figures for purposes of illustration.

For the sake of brevity, conventional semiconductor fabrication techniques may not be described in detail herein. In addition, certain terms may also be used herein for reference only, and thus are not intended to be limiting. For instance, the terms "first", "second", and other such numerical terms referring to structures do not imply a sequence or order unless clearly indicated by the context.

Various embodiments described herein relate to isolation structures having one or more air gaps formed in one or more dielectric layers disposed between two electrically conductive structures (e.g., upper and lower capacitor plates). In accordance with the embodiments, the air gap(s) are disposed at edges or corners of a lower surface of an upper conductive structure (e.g., corresponding to an upper capacitor plate) of the two conductive structures of a given isolation structure. The inclusion of air gap(s) at edges or corners of this conductive layer may advantageously reduce the risk of electrical breakdown (sometimes referred to herein as "dielectric breakdown") across the dielectric layer between the two conductive layers. For example, by including air gaps at edges or corners of a lower surface of an upper capacitor plate of a capacitive Galvanic isolation structure, the electric field strength at edges and/or corners of the lower surface of the upper capacitor plate may be reduced by a factor of around 3, resulting in reduced likelihood of dielectric breakdown across the isolation structure.

In one or more embodiments, the air gaps of the isolation structure may be formed in the dielectric layer only at corners of the lower surface of the upper conductive structure, such that the air gaps do not laterally overlap with respect to one another. In one or more other embodiments, the air gaps of the isolation structure may be formed in the dielectric layer at corners and edges (e.g., all corners and edges) of the lower surface of the upper conductive structure, such that a single air gap is formed surrounding the lower surface, overlapping the perimeter of the lower surface.

In one or more embodiments, the air gaps of the isolation structure may be formed in the dielectric layer subsequent to forming the upper conductive structure. For example, a patterned photoresist layer may be formed over the upper conductive structure and the dielectric layer, where the patterned photoresist layer includes openings located at the perimeter of the upper conductive structure. Portions of the dielectric layer may be etched through the openings in the photoresist layer to form the air gaps in the dielectric layer.

In one or more embodiments, after forming the air gaps in the dielectric layer, exposed surfaces of the upper conductive structure may be etched to round some or all corners and edges of the upper conductive structure. By rounding corners and edges of the upper conductive structure in this way, the electric field magnitude at such corners and edges may be further reduced.

In one or more embodiments, after forming the air gaps in the dielectric layer and before removing the photoresist layer, additional dielectric material, such as oxide, may be formed on exposed surfaces of the upper conductive structure, where at least some of the exposed surfaces are exposed through the air gap(s). In one or more embodiments, the additional dielectric material may include a native oxide layer that is formed by exposing the upper conductive structure to air for a predetermined time period. By forming the additional dielectric material on the exposed surfaces of the upper conductive structure in this way, the electric field magnitude at exposed corners and edges of the upper conductive structure may be further reduced.

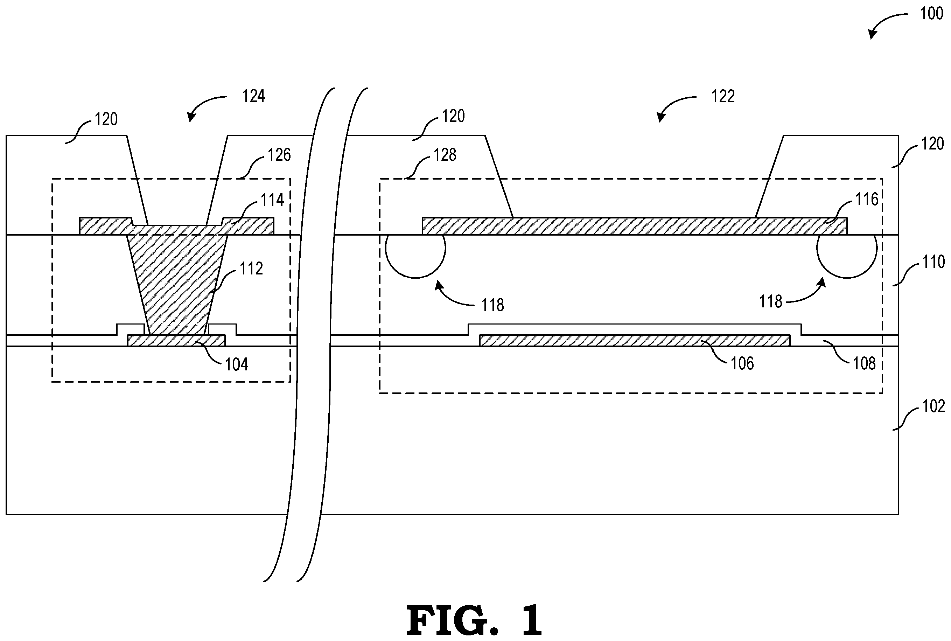

FIG. 1 is a cross-sectional side view of a semiconductor device 100 in accordance with one or more embodiments. In accordance with various embodiments, the semiconductor device 100 may include or may be included as part of a DC-DC converter, a battery charger, or a power supply, as non-limiting examples. The semiconductor device 100 includes a semiconductor substrate 102 on which a redistribution structure 126 and an isolation structure 128 are formed. The isolation structure 128 includes one or more air gaps 118 disposed in a dielectric layer 110 at locations where relatively high electric field strengths are expected during normal operation of the semiconductor device 100. As will be described, the air gaps 118 may reduce the electric field magnitudes at these locations, which may advantageously reduce the likelihood of dielectric breakdown across the isolation structure 128. It should be understood that only a portion of the semiconductor device 100 is shown in the present example, and that other device structures or components (e.g., vias, traces, transistors, diodes, capacitors, resistors, inductors, or other applicable device structures or components), in addition to those presently illustrated, may be formed in or on the semiconductor substrate 102 of the semiconductor device 100, in accordance with various embodiments.

The semiconductor substrate 102 may be formed from any applicable semiconductor material, such silicon, gallium nitride (GaN), gallium arsenide (GaAs), or silicon carbide (SiC), as non-limiting examples. The redistribution structure 126 may include an upper conductive structure 114, a lower conductive structure 104, and a conductive via 112 that electrically couples the upper conductive structure 114 to the lower conductive structure 104. The lower conductive structure 104 may be formed directly on a surface of the semiconductor substrate 102. A passivation layer 108 (e.g., formed from dielectric material such as an oxide or nitride material , which may include silicon dioxide, silicon oxy-nitride, or silicon nitride as non-limiting examples) may be at least partially disposed on the lower conductive structure. The dielectric layer 110 (e.g., including dielectric material such as polyimide, oxide, or nitride material as non-limiting examples) may be disposed on the passivation layer 108. The conductive via 112 extends from the lower conductive structure 104 to the upper conductive structure 114, passing through openings in the passivation layer 108 and the dielectric layer 110.

In one or more embodiments, the upper conductive structure 114 may be a bond pad to which wire bonds or solder balls, as non-limiting examples, may be coupled, where such wire bonds are solder balls may electrically couple the semiconductor device 100 to one or more external devices. In one or more embodiments, the lower conductive structure 104 may be a conductive trace that is part of a redistribution layer (RDL) or group of RDLs used to re-route connections of the semiconductor device 100 (e.g., to achieve a desired pitch between bond pads).

The isolation structure 128 includes an upper conductive structure 116 (sometimes referred to as an "upper capacitor plate 116"), a lower conductive structure 106 (sometimes referred to as a "lower capacitor plate 106"), a dielectric layer 110 (sometimes referred to herein as the "first dielectric layer 110") disposed between the upper conductive structure 116 and the lower conductive structure 106, and a passivation layer 108 disposed between the lower conductive structure 106 and the dielectric layer 110.

An additional dielectric layer 120 (sometimes referred to herein as the "second dielectric layer 120") may be formed over the dielectric layer 110 and the conductive structures 114, 116. The additional dielectric layer 120 may include dielectric material such as polyimide, oxide, or nitride material as non-limiting examples. Openings 122, 124 may be formed in the dielectric layer 120 to expose upper surfaces of the conductive structures 116, 114, respectively, allowing access to those surfaces for bonding.

In one or more embodiments, the lower conductive structure 106 has a thickness in a range of around 1 µm to around 3 µm. In one or more embodiments, the passivation layer 108 has a thickness in a range of around 3 µm to around 4 µm. In one or more embodiments, the dielectric layer 110 has a thickness in a range of around 10 µm to around 20 µm. In one or more embodiments, the upper conductive layer 116 has a thickness in a range of around 5 µm to around 20 µm. In one or more embodiments, the dielectric layer 120 has a thickness in a range of around 10 µm to around 20 µm.

In the isolation structure 128, the passivation layer 108 may cover upper and side surfaces of the lower conductive structure 106. The air gaps 118 are formed at edges and/or corners of the lower surface of the upper conductive structure 116. The air gaps 118 may be completely enclosed by surfaces of the dielectric layers 110, 120, and the upper conductive structure 116, such that each air gap 118 corresponds to a hermetically sealed space. In one or more embodiments, the air gaps 118 are formed only at corners of the lower surface of the upper conductive structure 116. In one or more such embodiments, the air gaps 118 are non-overlapping with respect to one another. In one or more other embodiments, the air gaps 118 are formed at all edges and corners of the lower surface of the upper conductive structure 116. In one or more such embodiments, the air gaps 118 overlap to form a single contiguous air gap that surrounds the edges and corners of the lower surface of the upper conductive structure 116, overlapping a perimeter of the lower surface of the upper conductive structure 116. In one or more embodiments, the air gaps 118 are backfilled with gas, such as sulfur hexafluoride (SF₆), nitrogen (N₂), or dichlorodifluoromethane (CF₂Cl₂) as non-limiting examples. In one or more such embodiments, the gas used to fill the air gaps 118 may have a breakdown voltage that is higher than that of air, thereby reducing the likelihood of dielectric breakdown between the upper conductive structure 116 and the lower conductive structure 106.

During normal operation of the device 100, electric field strength tend to be higher at corners and edges of the upper conductive structure 116, such that dielectric breakdown between the conductive structures 106, 116 across the dielectric layer 110 tends to originate from such corners or edges when the voltage differential between the upper conductive structure 116 and the lower conductive structure 106 is sufficiently high. By including the air gaps 118 at such corners and/or edges of the lower surface of the upper conductive structure 116, electric field strength in the regions at or near the air gaps 118 may be advantageously reduced (e.g., due to the air gaps 118 spreading the electric field over a wider area) thereby reducing the likelihood of dielectric breakdown across the isolation structure 128. For example, the air gaps 118 may advantageously reduce electric field strength by a factor of around 3 at the corners and/or edges of the lower surface of the upper conductive structure 116.

Each of the conductive structures 104, 106, 114, 116, and the via 112 may be formed from conductive material, such as metal. In various embodiments, each of the conductive structures 104, 106, 114, 116, and the via 112 may be formed from one or more layers of copper, nickel, aluminum, gold, or a combination of these, as non-limiting examples.

It should be understood that, while the isolation structure 128 is formed on a semiconductor substrate in the present example, this is intended to be illustrative and not limiting. In one or more other embodiments, for example, the isolation structure 128 may instead be formed on substrates other than semiconductor substrates, such as ceramic or glass substrates as non-limiting examples.

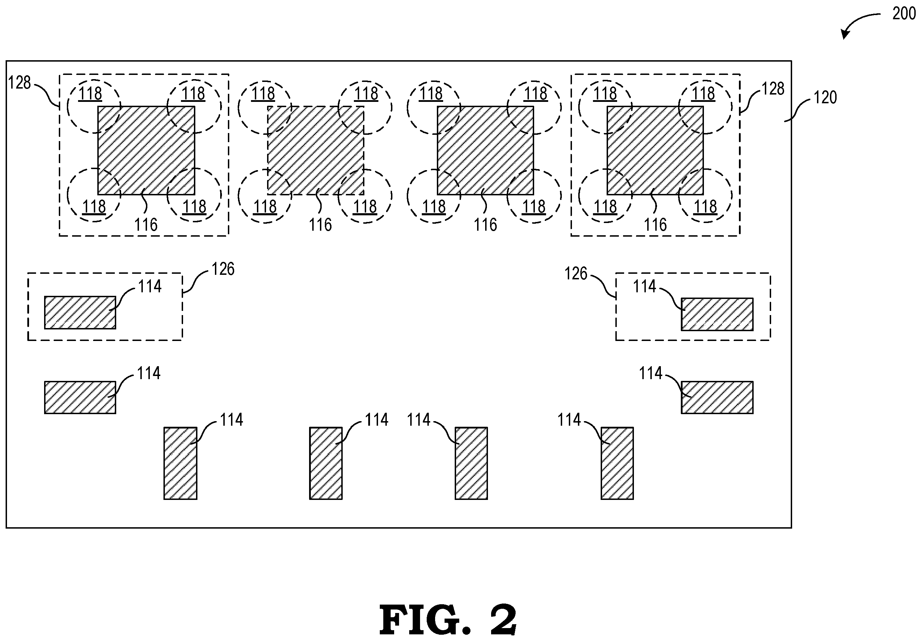

FIGS. 2 is a partially transparent top-down view of a semiconductor device 200, which may correspond to an example embodiment of the semiconductor device 100 of FIG. 1. It should be noted that various features of the semiconductor device 200 correspond to those described above in connection with the semiconductor device 100 of FIG. 1, with like reference numerals being used here to denote similar elements. Descriptions of such elements are not necessarily repeated here for sake of brevity.

In the present example, the semiconductor device 200 includes multiple isolation structures 128 and redistribution structures 126. Each of the isolation structures 128 includes air gaps 118 formed in the dielectric layer 110 (not presently shown; disposed under the dielectric layer 120 as shown in FIG. 1) at corners of the corresponding upper conductive structure 116. Each of the air gaps 118 of a given isolation structure 128 are non-overlapping with respect to one another.

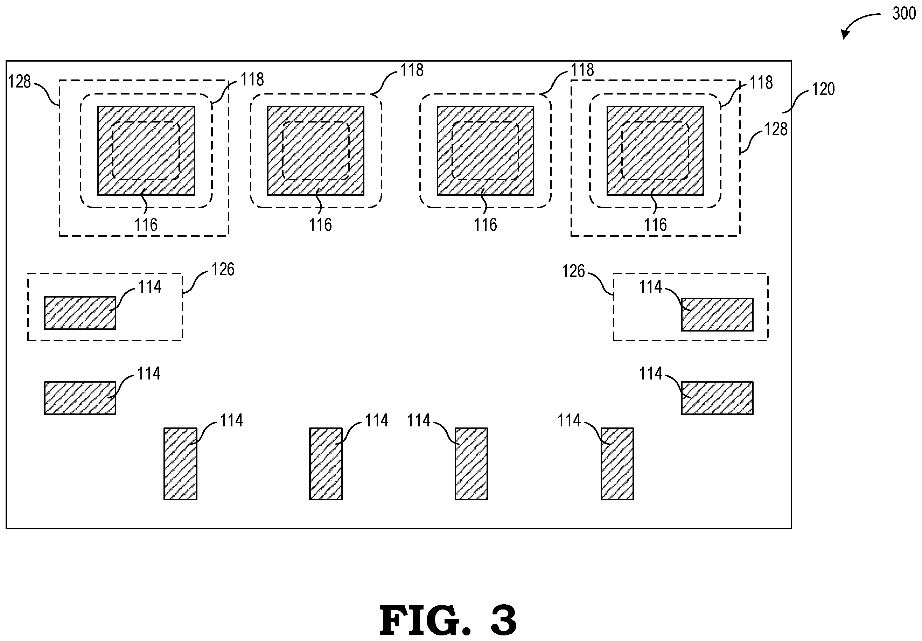

FIG. 3 is a partially transparent top-down view of a semiconductor device 300, which corresponds to an example embodiment of the semiconductor device 100 of FIG. 1. It should be noted that various features of the semiconductor device 300 correspond to those described above in connection with the semiconductor device 100 of FIG. 1, with like reference numerals being used here to denote similar elements. Descriptions of such elements are not necessarily repeated here for sake of brevity.

In the present example, the semiconductor device 300 includes multiple isolation structures 128 and redistribution structures 126. Each of the isolation structures 128 includes a single air gap formed in the dielectric layer 110 (not presently shown; disposed under the dielectric layer 120 as shown in FIG. 1) overlapping a perimeter of the corresponding upper conductive structure 116 (e.g., the perimeter of a lower surface of the conductive structure 116).

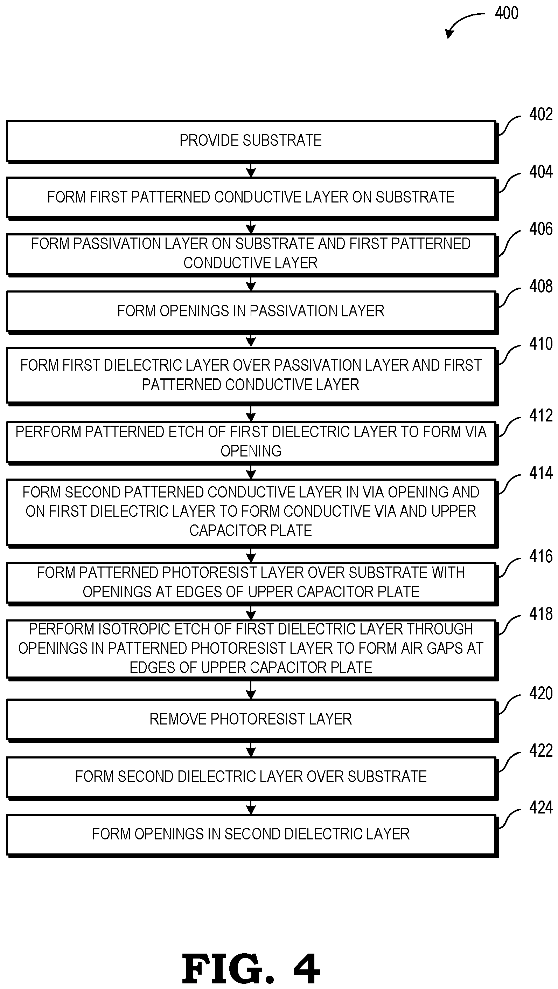

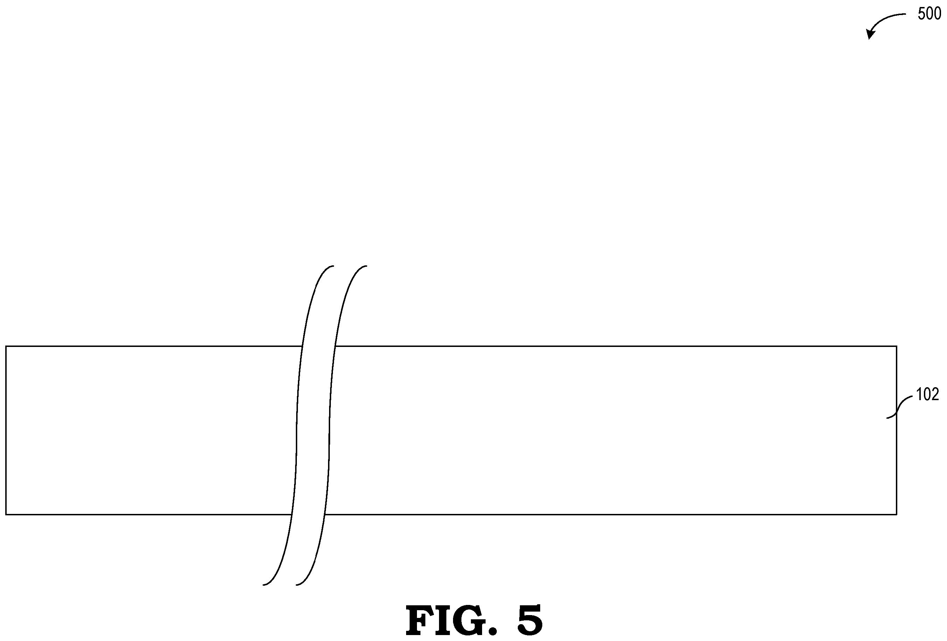

FIG. 4 is a process flow diagram depicting a method 400 for fabricating at least a portion of a semiconductor device, such as the semiconductor device 100 of FIG. 1, in accordance with various embodiments. For enhanced understanding, FIG. 4 may be viewed simultaneously with FIGS. 5-15, which are cross sectional views depicting the semiconductor device 100 of FIG. 1 at various stages of fabrication, in accordance with various embodiments.

Referring first to step 402 of FIG. 4 and to FIG. 5, at a first stage of fabrication 500, a semiconductor substrate 102 is provided. As mentioned previously, the semiconductor substrate 102 may be formed from any applicable semiconductor material, such silicon, gallium nitride (GaN), gallium arsenide (GaAs), or silicon carbide (SiC), as non-limiting examples.

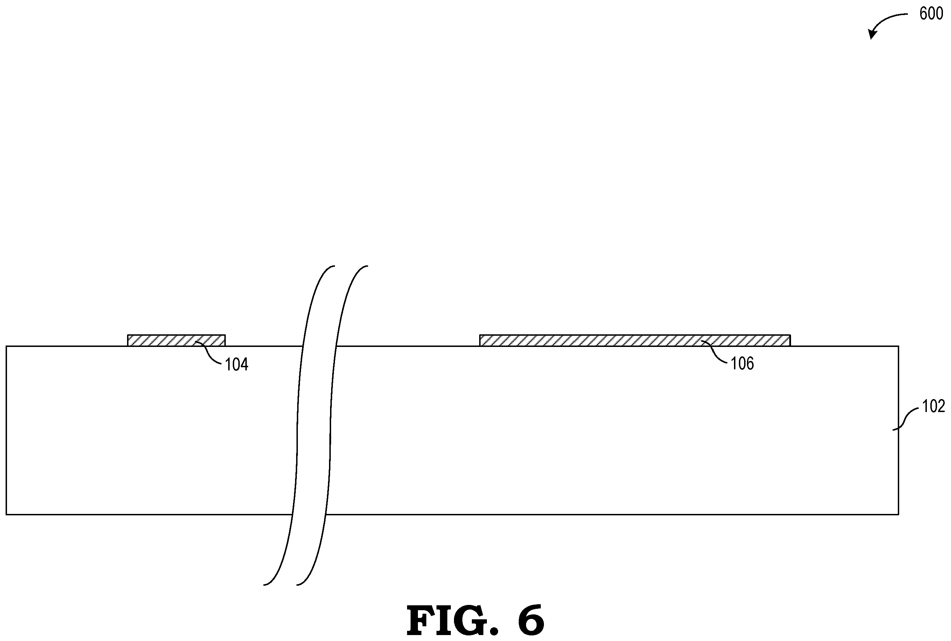

Referring first to step 404 of FIG. 4 and to FIG. 6, at a stage of fabrication 600, a first patterned conductive layer is formed on the substrate 102. The first patterned conductive layer may include a lower conductive structure 104 and a lower capacitor plate 106. The first patterned conductive layer may be formed, for example, by depositing metal (e.g., copper, aluminum, nickel, gold, or other applicable metals) on a surface of the substrate 102, then patterning the metal via selective etching in combination with a suitable photolithographic process.

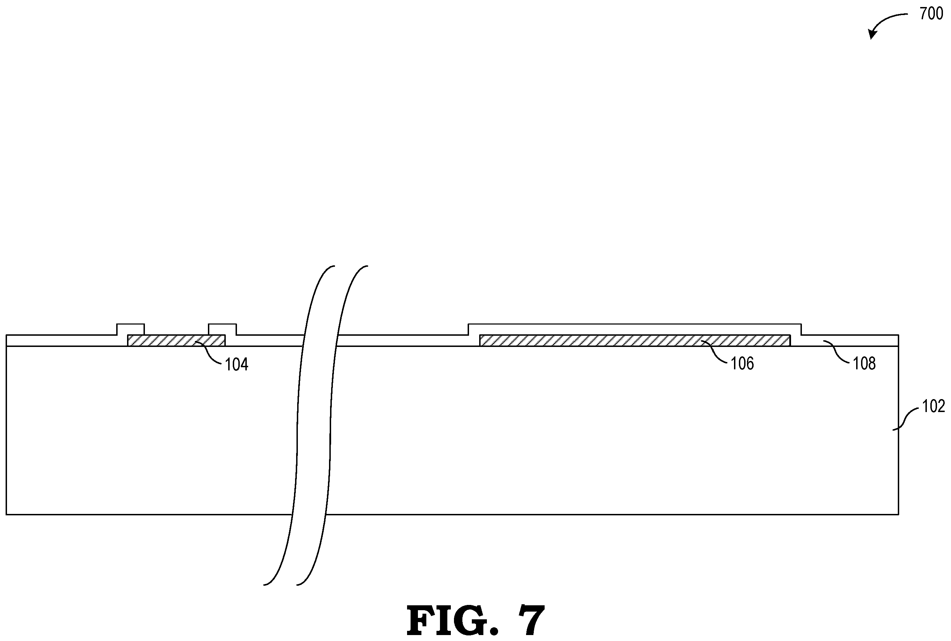

Referring first to steps 406 and 408 of FIG. 4 and to FIG. 7, at a stage of fabrication 700, a passivation layer 108 is formed over the substrate 102 and the first patterned conductive layer, including the conductive structures 104, 106, then openings are formed in the passivation layer 108 via a suitable etch process. For example, at step 406, the passivation layer 108 may be formed by depositing dielectric material such as dielectric oxide or nitride material on the exposed surfaces of the substrate 102 and the first patterned conductive layer using a suitable deposition process (e.g., chemical vapor deposition (CVD), plasma enhanced CVD (PECVD), or another suitable deposition process). For example, at step 408, openings may be formed in the passivation layer 108 via a patterned etch process, including an opening that overlaps the lower conductive structure 104, such that an upper surface of the lower conductive structure 104 is exposed through the opening in the passivation layer 108. Herein, a "patterned etch process" refers to a process in which etching of material is performed in conjunction with a photolithographic process, such that the material is etched through openings in a patterned photoresist layer. In the present example, performing the patterned etch process may include performing a wet etch process (e.g., a buffered oxide etch (BOE)) or another suitable wet chemical etch process) or dry etch process (e.g., a reactive ion etch (RIE) or another suitable dry etch process) to remove portions of the passivation layer 108.

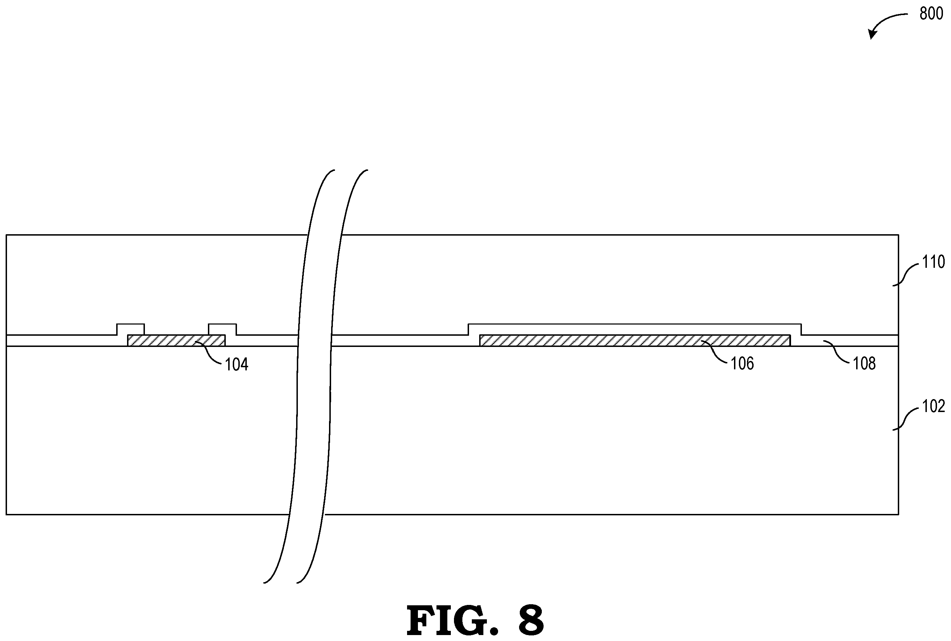

Referring first to step 410 of FIG. 4 and to FIG. 8, at a stage of fabrication 800, a first dielectric layer 110 is formed over the passivation layer 108. The first dielectric layer 110 may contact surfaces of the passivation layer 108 and the surface of the lower conductive structure 104 that is exposed through the opening in the passivation layer 108. For example, the first dielectric layer 110 may be formed by depositing dielectric material such as polyimide on the exposed surfaces of the passivation layer 108 and the lower conductive structure 104 using a suitable deposition or coating process. In one or more embodiments in which the first dielectric layer 110 includes polyimide material, the first dielectric layer 110 may be formed by spin coating uncured polyimide resin over the substrate 102, then curing the resin at a suitable temperature. In one or more embodiments in which the first dielectric layer 110 includes oxide material or nitride material, the first dielectric layer 110 may be formed via CVD.

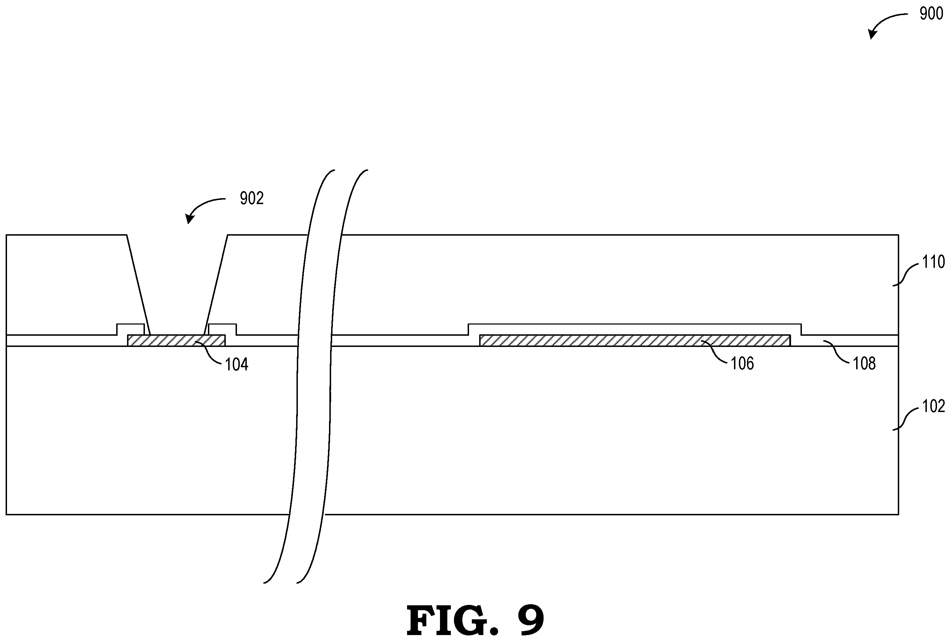

Referring first to step 412 of FIG. 4 and to FIG. 9, at a stage of fabrication 900, a patterned etch process is performed to remove portions of the first dielectric layer 110. Removal of these portions of the first dielectric layer 110 (e.g., via wet chemical etch as a non-limiting example) may form an opening 902 that extends through both the first dielectric layer 110 and the opening in the passivation layer 108 to expose the upper surface of the lower conductive structure 104.

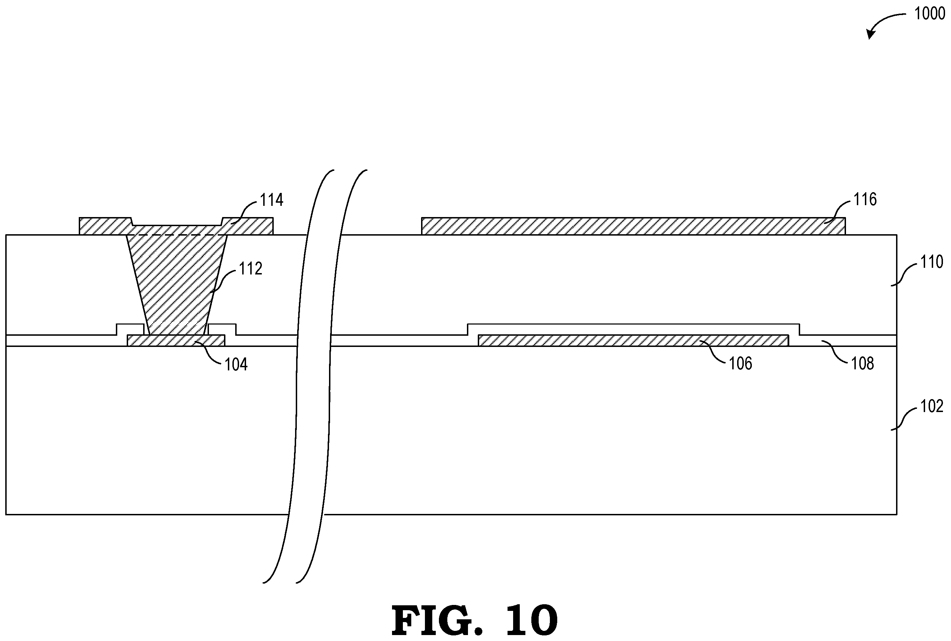

Referring first to step 414 of FIG. 4 and to FIG. 10, at a stage of fabrication 1000, a second patterned conductive layer is formed over the substrate 102, which includes an upper conductive structure 114 disposed directly over a lower conductive structure 104, an upper capacitor plate 116 disposed directly over a lower capacitor plate 106, and the conductive via 112 disposed in the opening 902 that was formed at step 412. The second patterned conductive layer may be formed, for example, by depositing metal (e.g., copper, aluminum, nickel, gold, or other applicable metals) on a surface of the substrate 102, then patterning the metal via selective etching in combination with a suitable photolithographic process. The upper capacitor plate 116 and the lower capacitor plate 106 may be capacitively coupled, with the upper conductive structure corresponding to an upper capacitor plate and the lower capacitor plate 106.

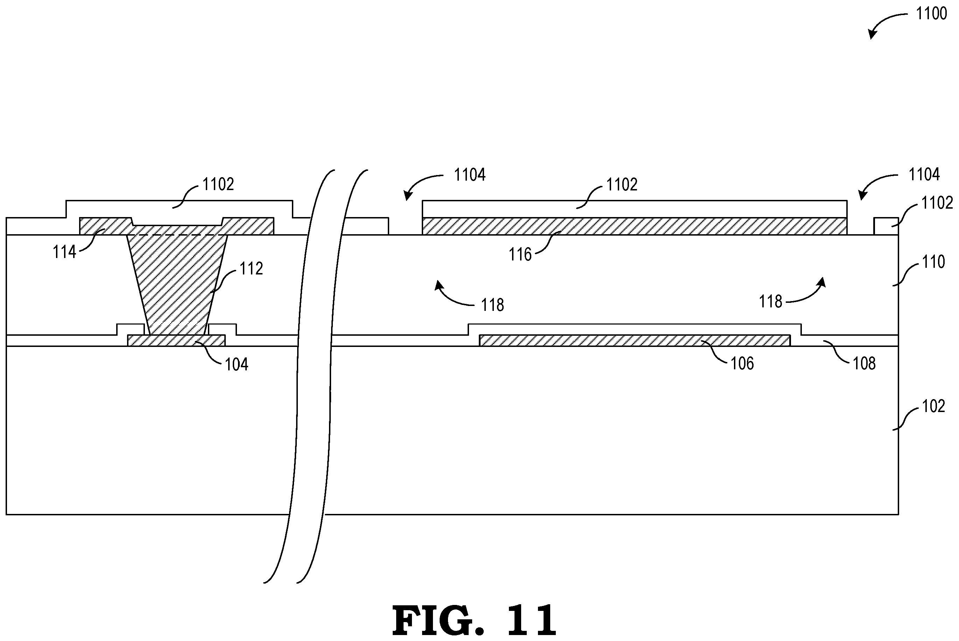

Referring first to step 416 of FIG. 4 and to FIG. 11, at a stage of fabrication 1100, a patterned photoresist layer 1102 is formed over the substrate 102. The patterned photoresist layer 1102 may be formed as part of a suitable photolithographic process. The patterned photoresist layer 1102 may include portions that are formed on surfaces of the first dielectric layer 110, the upper conductive structure 114, and the upper capacitor plate 116. The patterned photoresist layer 1102 includes openings 1104 disposed adjacent to edges of the upper capacitor plate 116. Portions of the upper surface of the first dielectric layer 110 are exposed through the openings 1104.

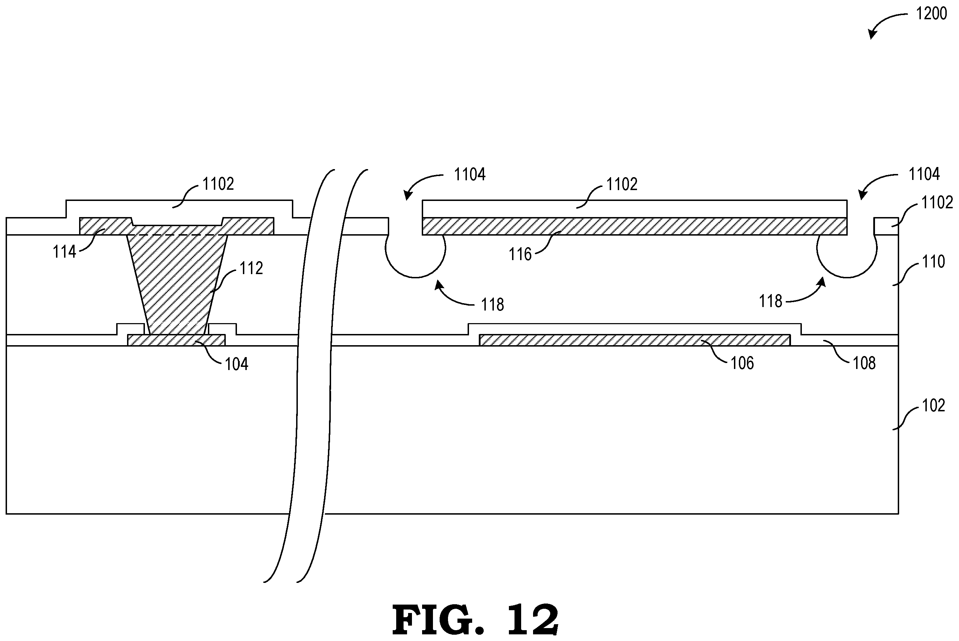

Referring first to step 418 of FIG. 4 and to FIG. 12, at a stage of fabrication 1200, an isotropic etch (e.g., a chemical wet etch) is performed through the openings 1104 to remove portions of the first dielectric layer 110, thereby forming air gaps 118 in the first dielectric layer 110. The air gaps 118 may be disposed at corners and/or edges of a lower surface of the upper capacitor plate 116.

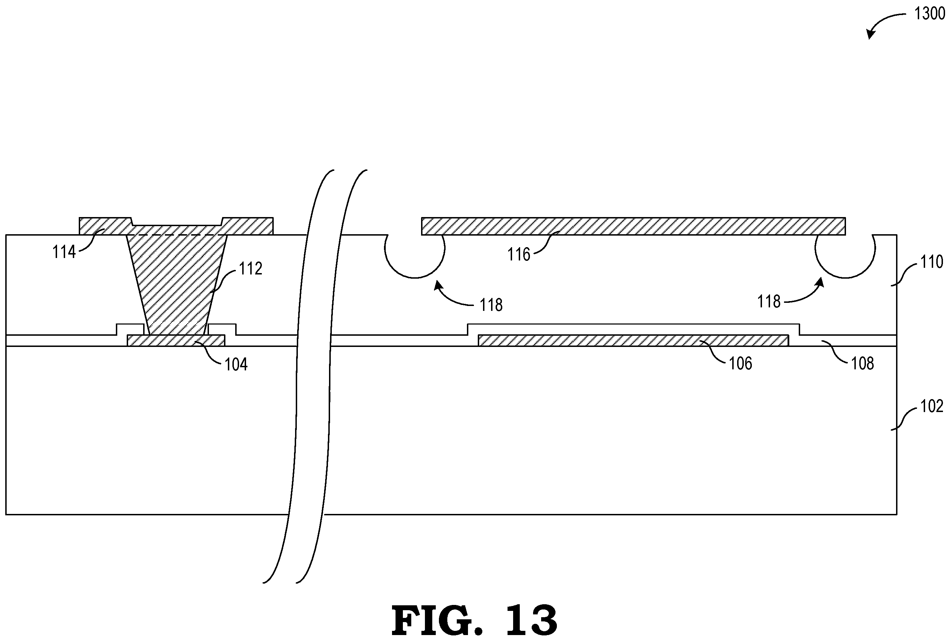

Referring first to step 420 of FIG. 4 and to FIG. 13, at a stage of fabrication 1300, the patterned photoresist layer 1102 is removed via application of solvents or alkaline media as non-limiting examples.

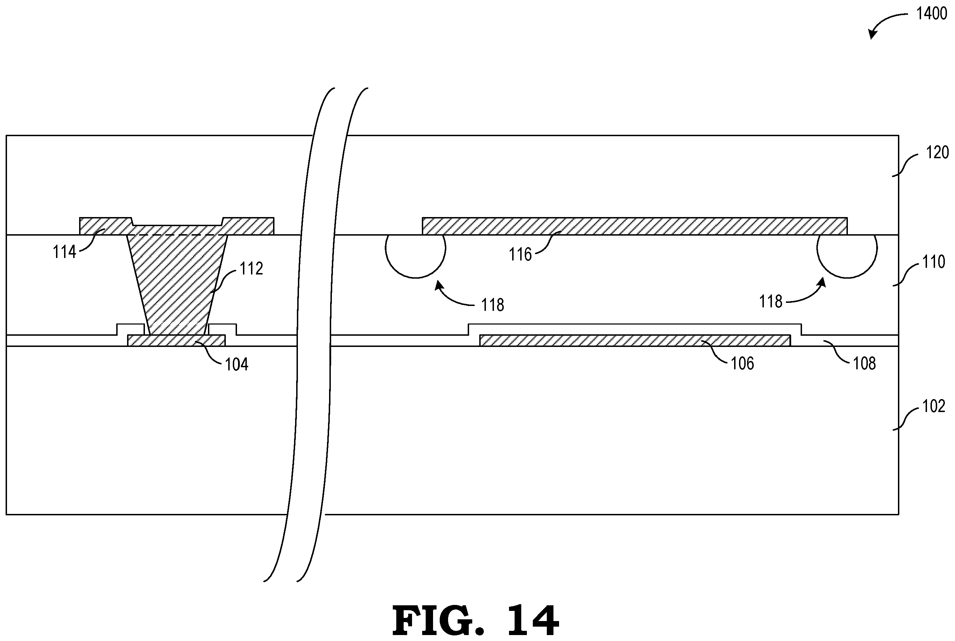

Referring first to step 422 of FIG. 4 and to FIG. 14, at a stage of fabrication 1400, a second dielectric layer 120 is formed over the first dielectric layer 110 and the conductive structures 114, 116. The second dielectric layer 120 may contact surfaces of the first dielectric layer 110, and surfaces of the conductive structures 114, 116. For example, the second dielectric layer 120 may be formed by depositing dielectric material such as polyimide on the exposed surfaces of the first dielectric layer 110 and the conductive structures 114, 116 using a suitable deposition or coating process. In one or more embodiments in which the second dielectric layer 120 includes polyimide material, the second dielectric layer 120 may be formed by spin coating uncured polyimide resin over the substrate 102, then curing the resin at a suitable temperature. In one or more embodiments in which the first dielectric layer 110 includes oxide material or nitride material, the second dielectric layer 120 may be formed via CVD.

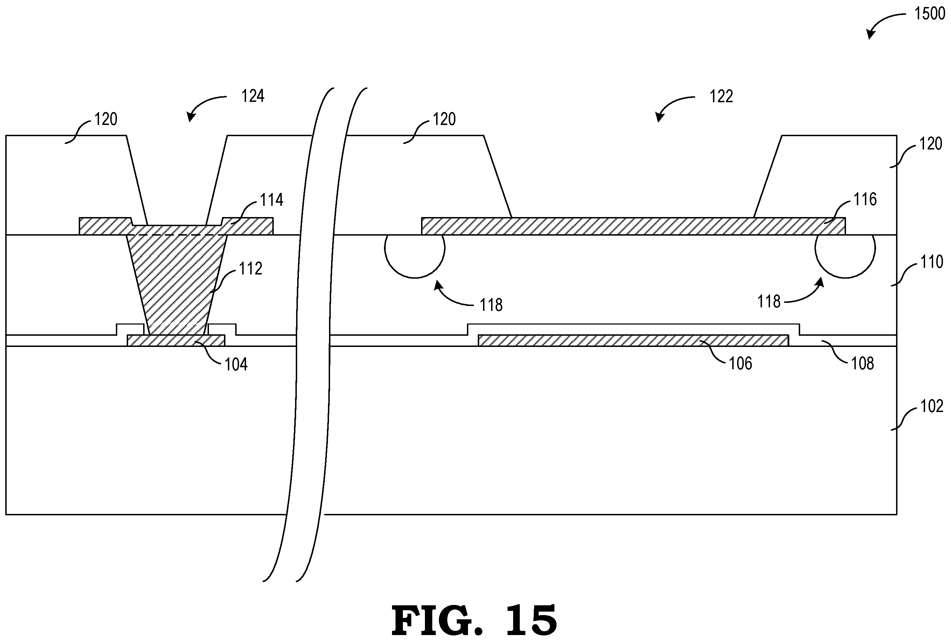

Referring first to step 424 of FIG. 4 and to FIG. 15, at a stage of fabrication 1500, openings 122, 124 are formed through the second dielectric layer 120 to expose surfaces of the conductive structures 114, 116. For example, the openings 122, 124 may be formed by performing a patterned etch (e.g., including a wet chemical etch, as a non-limiting example) of portions of the second dielectric layer 120. Surfaces of the conductive structures 114, 116 that are exposed through the openings 122, 124 may be used as bonding surfaces for subsequent bonding processes (e.g., wire bonding, ball bonding, or other suitable bonding processes).

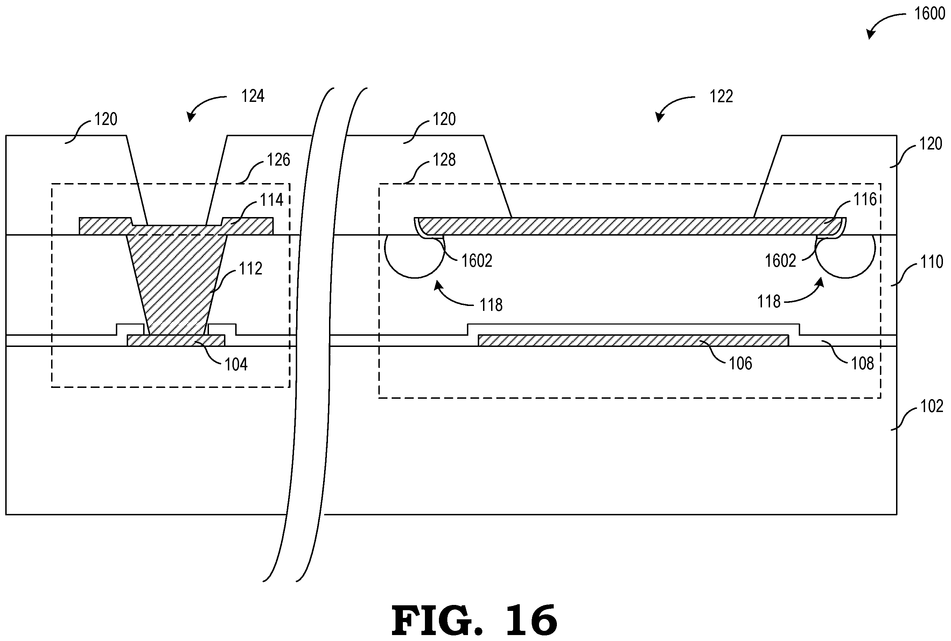

FIG. 16 is a cross-sectional side-view of a semiconductor device 1600 that includes an isolation structure 128 having an upper capacitor plate 116 of which corners and edges exposed through air gaps 118 are rounded and covered with a thin (e.g., around 100 angstroms to 1000 angstroms) layer of dielectric material 1602, which may be oxide material. In the present example, the air gaps 118 may be enclosed, in part, by the dielectric material 1602. It should be noted that various features of the semiconductor device 1600 correspond to those described above in connection with the semiconductor device 100 of FIG. 1, with like reference numerals being used here to denote similar elements. Descriptions of such elements are not necessarily repeated here for sake of brevity.

Electric field strength tends to be higher and more concentrated at edges and corners (particularly sharp edges and corners) of an electrically conductive element to which an electric charge has been applied. By rounding (e.g., via etching, such as wet chemical etching) the edges and corners that define the boundary of the lower surface of the upper conductive structure 116, the concentration of electric field strength at such edges and corners may be further reduced, which may advantageously reduce the likelihood of dielectric breakdown across the isolation structure 128.

In various embodiments, the dielectric material 1602 may be an oxide or other suitable dielectric material. In one or more embodiments, the dielectric material 1602 is a native oxide that is formed by exposing the surfaces of the upper capacitor plate 116 on which the dielectric material 1602 is to be formed to air for a predetermined time period. For example, the predetermined time period may be between around 12 hours to around 24 hours, during which the exposed surfaces of the capacitor plate 116 are exposed to air, resulting in the formation of native oxide on those surfaces.

In one or more embodiments, the dielectric material 1602 includes oxide material and the dielectric layer 110 includes polyimide material. In such embodiments, the oxide material may increase the work function at the surfaces of the upper conductive structure 116 on which it is disposed (e.g., a work function of copper oxide (CuO) is around 5.3 eV, whereas the work function of metallic Cu is around 4.7 eV). A higher work function typically corresponds to a lower likelihood of dielectric breakdown. By forming the dielectric material 1602 on surfaces (including edges and corners) of the upper capacitor plate 116 that are exposed through the air gaps 118, the likelihood of dielectric breakdown across the isolation structure 128 may be advantageously reduced.

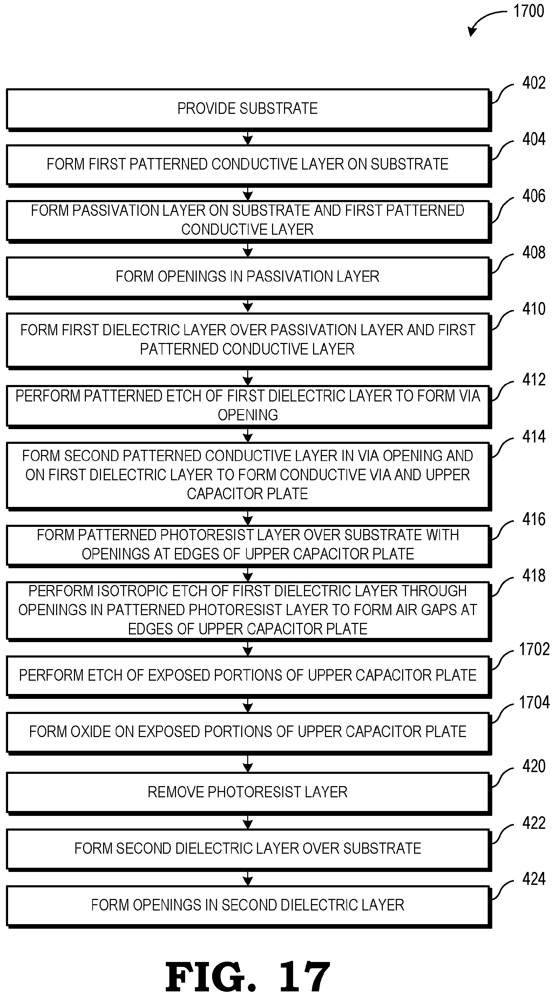

FIG. 17 is a process flow diagram depicting a method 1700 for fabricating at least a portion of a semiconductor device, such as the semiconductor device 1600 of FIG. 16, in accordance with various embodiments. It should be noted that many of the steps of the method 1700 correspond to similar steps described above in connection with the method 400 of FIG. 4, with like reference numerals being used here to denote similar steps. Descriptions of such steps are not repeated here for sake of brevity. In one or more embodiments, compared to the method 400 of FIG. 4, the method 1700 may include additional steps 1702 and 1704 to be performed after the step 418 (formation of the air gaps 118 via isotropic etching) and before the step 420 (removal of the photoresist layer 1102). For enhanced understanding, the steps 1702 and 1704 of FIG. 17 may be viewed simultaneously with at least FIGS. 5-11 and FIGS. 18 and 19, which are cross-sectional views depicting the semiconductor device 1600 of FIG. 16 at various stages of fabrication, in accordance with various embodiments.

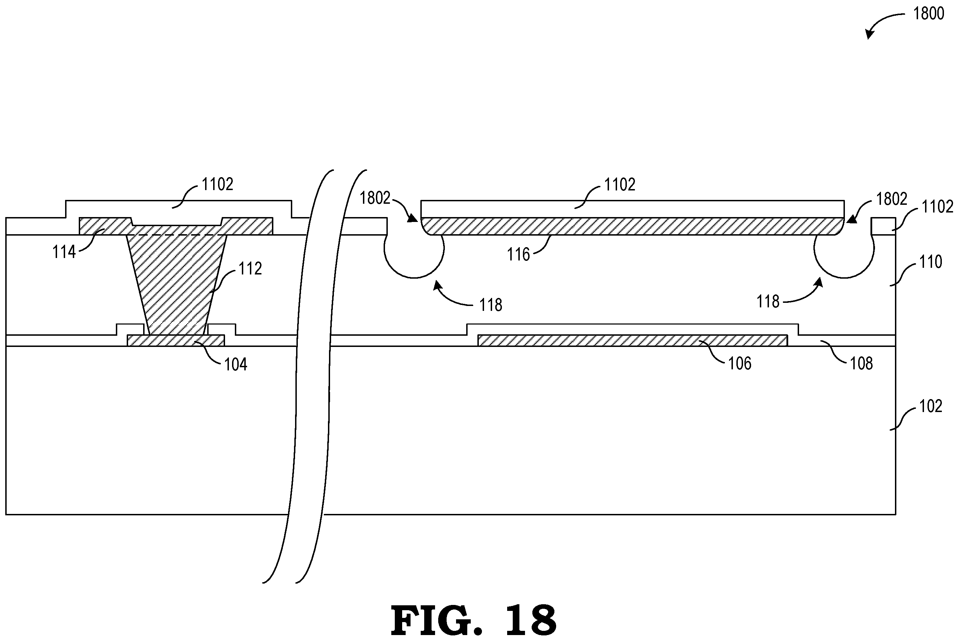

Referring to step 1702 of FIG. 17 and to FIG. 18, at a stage of fabrication 1800, after formation of the air gaps 118 and prior to removing the patterned photoresist layer 1102, exposed portions 1802 of the upper capacitor plate 116 are etched using a suitable etch process (e.g., wet chemical etching as a non-limiting example). The etched portions 1802 include exposed edges and corners that at least partially define the perimeter of the lower surface of the upper capacitor plate 116. The exposed portions 1802 are exposed through the openings in the patterned photoresist layer 1102 and the air gaps 118. During etching of the exposed portions 1802, the upper surface of the upper capacitor plate 116 is protected by the patterned photoresist layer 1102 disposed thereon. Etching the exposed portions 1802 of the upper capacitor plate 116 may reduce the sharpness of edges and corners of the exposed portions 1802 (i.e., these edges and corners may be softened or rounded as the etchant removes material from the exposed portions 1802). Because electric field strength is typically more concentrated at sharp edges and corners, the magnitude of the electric field strength in the regions of the exposed portions 1802 (i.e., after completion of the method 1700 and during normal operation of the corresponding semiconductor device) may be advantageously reduced by reducing the sharpness of the edges and corners of the exposed portions 1802 in this way. This reduction in electric field strength concentration at the exposed portions 1802 may advantageously reduce the likelihood of dielectric breakdown between the upper capacitor plate 116 and the lower capacitor plate 106.

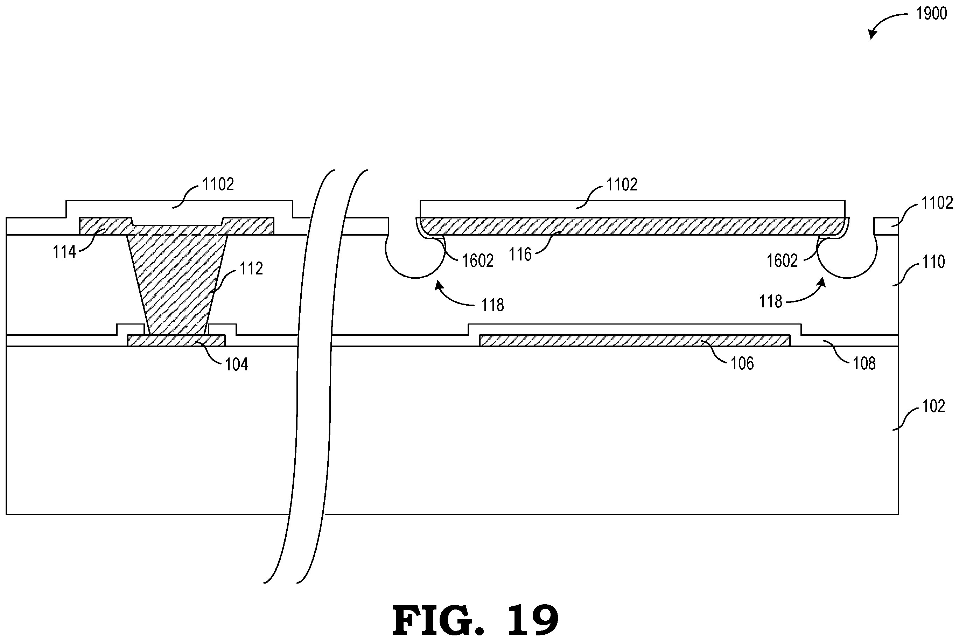

Referring to step 1704 of FIG. 17 and to FIG. 19, at a stage of fabrication 1900, dielectric material 1602, which may correspond to a thin layer of oxide material, is formed on the exposed portions 1802 of the upper capacitor plate 116. In one or more embodiments, the dielectric material 1602 includes one or more native oxide layers formed by exposing the exposed portions 1802 to air for a predetermined time period. In one or more other embodiments, the dielectric material 1602 is formed by treating the exposed portions 1802 with an oxidizing agent, such as hydrogen peroxide (H₂O₂). In one or more embodiments, electrochemical polishing may be performed on the exposed portions 1802 after formation of the air gaps (e.g., prior to formation of the dielectric material 1602) to improve the smoothness and uniformity of the exposed portions 1802. By forming the dielectric material 1602 on the exposed portions 1802 (including at least some of the edges and corners of the upper capacitor plate 116), the likelihood of dielectric breakdown across the isolation structure 128 may be advantageously reduced.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in one or more embodiments of the depicted subject matter. Furthermore, the term "amplifier" used herein should be understood to refer to a "power amplifier" unless noted otherwise.

## Claims

1. A semiconductor device (100) comprising:
a semiconductor substrate (102); and
a galvanic isolation structure (128) comprising:
a first dielectric layer (110) disposed over the semiconductor substrate (102), the first dielectric layer (110) including one or more air gaps (118); and
a first conductive structure (116) formed on the dielectric layer, the conductive structure (116) having a lower surface that faces the semiconductor substrate (102), wherein respective air gaps of the one or more air gaps (118) of the first dielectric layer (110) are each disposed directly between corners of the lower surface of the conductive structure (116) and the semiconductor substrate (102); wherein the isolation structure (128) further comprises:
a second conductive structure (106) disposed directly on the semiconductor substrate (102), wherein the second conductive structure (106) is capacitively coupled to the first conductive structure (116), and wherein the one or more air gaps (118) are arranged to reduce the electric field strength between the corners of the lower surface of the conductive structure (116) and the second conductive structure (106).

2. The semiconductor device (100) of claim 1, further comprising:
a third conductive structure (114) disposed directly on the semiconductor substrate (102);
a fourth conductive structure (104) disposed at least partially on the first dielectric layer (110), wherein the fourth conductive structure (104) and the first conductive structure (116) are formed in the same layer; and
a conductive via (112) that extends through the first dielectric layer (110) between the first conductive structure (116) and the third conductive structure (114), such that the conductive via (112) electrically connects the fourth conductive structure (104) to the third conductive structure (114).

3. The semiconductor device (100) of claim 1 or 2, further comprising:
a second dielectric layer (120) disposed over the first conductive structure (116) and the first dielectric layer (110).

4. The semiconductor device (100) of claim 3, wherein the second dielectric layer (120) includes an opening that overlaps the first conductive structure (116), such that an upper surface of the first conductive structure (116) is exposed through the opening.

5. The semiconductor device (100) of any preceding claim, wherein the one or more air gaps (118) in the first dielectric layer (110) are disposed directly between edges of the lower surface of the first conductive structure (116) and the semiconductor substrate (102), such that the one or more air gaps overlap a perimeter of the lower surface of the first conductive structure (116).

6. The semiconductor device (100) of any preceding claim, wherein the one or more air gaps (118) in the first dielectric layer (110) are disposed only at the corners of the lower surface of the first conductive structure (116).

7. The semiconductor device (100) of any preceding claim, further comprising:
oxide material disposed on one or more surfaces of the first conductive structure (116) at the corners of the first conductive structure (116), such that the oxide material separates the corners of the first conductive structure (116) from the one or more air gaps (118) in the first dielectric layer (110).

8. The semiconductor device (100) of any preceding claim, further comprising:
a second dielectric layer (120) disposed over the first dielectric layer (110) and the first conductive structure (116), the second dielectric layer (120) including at least one opening through which an upper surface of the first conductive structure (116) is exposed.

9. A method of fabricating a semiconductor device (100), the method comprising:
providing a substrate (102);
forming a first patterned conductive layer on the substrate (102), the first patterned conductive layer including a first capacitor plate (116);
forming a first dielectric layer (110) over the first patterned conductive layer;
forming a second patterned conductive layer over the first dielectric layer (110), the second patterned conductive layer including a second capacitor plate (106);
forming a patterned photoresist layer over the substrate (102), the patterned photoresist layer including openings at one or more edges of the second capacitor plate (106); and
etching portions of the first dielectric layer (110) through the openings in the patterned photoresist layer to form air gaps (118) at the edges of the second capacitor plate (106).

10. The method of claim 9, wherein etching the portions of the first dielectric layer (110) through the openings in the patterned photoresist layer to form air gaps at the edges of the second capacitor plate (106) comprises:
etching the portions of the first dielectric layer (110) through the openings in the patterned photoresist layer to form air gaps at the edges of the second capacitor plate (106).

11. The method of claim 9 or 10, wherein the first patterned conductive layer further includes a first conductive structure (114), and the second patterned conductive layer further includes a second conductive structure (104) and a conductive via (112) that electrically couples the first conductive structure (114) to the second conductive structure (104).

12. The method of claim 11, further comprising:
performing a patterned etch of the first dielectric layer (110) to form an opening in the first dielectric layer (110), wherein the conductive via (112) is subsequently formed in the opening in the first dielectric layer (110).

13. The method of any one of claims 9 to 12, further comprising:
after forming the air gaps (118) at the edges of the second capacitor plate (106), etching exposed portions of the second capacitor plate (106).

14. The method of claim 13, wherein etching the exposed portions of the second capacitor plate (106) causes edges and corners of the second capacitor plate (106) to be rounded.

## Patentansprüche

1. Halbleitervorrichtung (100), umfassend:
ein Halbleitersubstrat (102); und
eine galvanische Isolationsstruktur (128), umfassend:
eine erste dielektrische Schicht (110), die über dem Halbleitersubstrat (102) angeordnet ist, wobei die erste dielektrische Schicht (110) einen oder mehrere Luftspalte (118) beinhaltet; und
eine erste leitfähige Struktur (116), die auf der dielektrischen Schicht gebildet ist, wobei die leitfähige Struktur (116) eine untere Oberfläche aufweist, die dem Halbleitersubstrat (102) zugewandt ist, wobei jeweilige Luftspalte des einen oder der mehreren Luftspalte (118) der ersten dielektrischen Schicht (110) jeweils direkt zwischen Ecken der unteren Oberfläche der leitfähigen Struktur (116) und dem Halbleitersubstrat (102) angeordnet sind; wobei die Isolationsstruktur (128) ferner Folgendes umfasst:
eine zweite leitfähige Struktur (106), die direkt auf dem Halbleitersubstrat (102) angeordnet ist, wobei die zweite leitfähige Struktur (106) kapazitiv mit der ersten leitfähigen Struktur (116) gekoppelt ist, und wobei der eine oder die mehreren Luftspalte (118) dazu angeordnet sind, die elektrische Feldstärke zwischen den Ecken der unteren Oberfläche der leitfähigen Struktur (116) und der zweiten leitfähigen Struktur (106) zu reduzieren.

2. Halbleitervorrichtung (100) nach Anspruch 1, ferner umfassend:
eine dritte leitfähige Struktur (114), die direkt auf dem Halbleitersubstrat (102) angeordnet ist;
eine vierte leitfähige Struktur (104), die zumindest teilweise auf der ersten dielektrischen Schicht (110) angeordnet ist, wobei die vierte leitfähige Struktur (104) und die erste leitfähige Struktur (116) in derselben Schicht gebildet sind; und
ein leitfähiges Via (112), das sich durch die erste dielektrische Schicht (110) zwischen der ersten leitfähigen Struktur (116) und der dritten leitfähigen Struktur (114) erstreckt, so dass das leitfähige Via (112) die vierte leitfähige Struktur (104) elektrisch mit der dritten leitfähigen Struktur (114) verbindet.

3. Halbleitervorrichtung (100) nach Anspruch 1 oder 2, ferner umfassend:
eine zweite dielektrische Schicht (120), die über der ersten leitfähigen Struktur (116) und der ersten dielektrischen Schicht (110) angeordnet ist.

4. Halbleitervorrichtung (100) nach Anspruch 3, wobei die zweite dielektrische Schicht (120) eine Öffnung beinhaltet, die die erste leitfähige Struktur (116) überlappt, so dass eine obere Oberfläche der ersten leitfähigen Struktur (116) durch die Öffnung freigelegt ist.

5. Halbleitervorrichtung (100) nach einem der vorhergehenden Ansprüche, wobei der eine oder die mehreren Luftspalte (118) in der ersten dielektrischen Schicht (110) direkt zwischen Kanten der unteren Oberfläche der ersten leitfähigen Struktur (116) und dem Halbleitersubstrat (102) angeordnet sind, so dass der eine oder die mehreren Luftspalte einen Umfang der unteren Oberfläche der ersten leitfähigen Struktur (116) überlappen.

6. Halbleitervorrichtung (100) nach einem der vorhergehenden Ansprüche, wobei der eine oder die mehreren Luftspalte (118) in der ersten dielektrischen Schicht (110) nur an den Ecken der unteren Oberfläche der ersten leitfähigen Struktur (116) angeordnet sind.

7. Halbleitervorrichtung (100) nach einem der vorhergehenden Ansprüche, ferner umfassend:
ein Oxidmaterial, das auf einer oder mehreren Oberflächen der ersten leitfähigen Struktur (116) an den Ecken der ersten leitfähigen Struktur (116) angeordnet ist, so dass das Oxidmaterial die Ecken der ersten leitfähigen Struktur (116) von dem einen oder den mehreren Luftspalten (118) in der ersten dielektrischen Schicht (110) trennt.

8. Halbleitervorrichtung (100) nach einem der vorhergehenden Ansprüche, ferner umfassend:
eine zweite dielektrische Schicht (120), die über der ersten dielektrischen Schicht (110) und der ersten leitfähigen Struktur (116) angeordnet ist, wobei die zweite dielektrische Schicht (120) mindestens eine Öffnung beinhaltet, durch die eine obere Oberfläche der ersten leitfähigen Struktur (116) freigelegt ist.

9. Verfahren zum Fertigen einer Halbleitervorrichtung (100), wobei das Verfahren Folgendes umfasst:
Bereitstellen eines Substrats (102);
Bilden einer ersten strukturierten leitfähigen Schicht auf dem Substrat (102), wobei die erste strukturierte leitfähige Schicht eine erste Kondensatorplatte (116) beinhaltet;
Bilden einer ersten dielektrischen Schicht (110) über der ersten strukturierten leitfähigen Schicht;
Bilden einer zweiten strukturierten leitfähigen Schicht über der ersten dielektrischen Schicht (110), wobei die zweite strukturierte leitfähige Schicht eine zweite Kondensatorplatte (106) beinhaltet;
Bilden einer strukturierten Fotolackschicht über dem Substrat (102), wobei die strukturierte Fotolackschicht Öffnungen an einer oder mehreren Kanten der zweiten Kondensatorplatte (106) beinhaltet; und
Ätzen von Teilen der ersten dielektrischen Schicht (110) durch die Öffnungen in der strukturierten Fotolackschicht, um Luftspalte (118) an den Kanten der zweiten Kondensatorplatte (106) zu bilden.

10. Verfahren nach Anspruch 9, wobei das Ätzen der Teile der ersten dielektrischen Schicht (110) durch die Öffnungen in der strukturierten Fotolackschicht, um Luftspalte an den Kanten der zweiten Kondensatorplatte (106) zu bilden, Folgendes umfasst:
Ätzen der Teile der ersten dielektrischen Schicht (110) durch die Öffnungen in der strukturierten Fotolackschicht, um Luftspalte an den Kanten der zweiten Kondensatorplatte (106) zu bilden.

11. Verfahren nach Anspruch 9 oder 10, wobei die erste strukturierte leitfähige Schicht ferner eine erste leitfähige Struktur (114) beinhaltet, und die zweite strukturierte leitfähige Schicht ferner eine zweite leitfähige Struktur (104) und ein leitfähiges Via (112) beinhaltet, das die erste leitfähige Struktur (114) elektrisch mit der zweiten leitfähigen Struktur (104) koppelt.

12. Verfahren nach Anspruch 11, ferner umfassend: Durchführen einer strukturierten Ätzung der ersten dielektrischen Schicht (110), um eine Öffnung in der ersten dielektrischen Schicht (110) zu bilden, wobei das leitfähige Via (112) anschließend in der Öffnung in der ersten dielektrischen Schicht (110) gebildet wird.

13. Verfahren nach einem der Ansprüche 9 bis 12, ferner umfassend:
nach Bilden der Luftspalte (118) an den Kanten der zweiten Kondensatorplatte (106), Ätzen freiliegender Teile der zweiten Kondensatorplatte (106).

14. Verfahren nach Anspruch 13, wobei Ätzen der freiliegenden Teile der zweiten Kondensatorplatte (106) bewirkt, dass Kanten und Ecken der zweiten Kondensatorplatte (106) abgerundet werden.

## Revendications

1. Dispositif (100) à semi-conducteur comprenant :
un substrat semi-conducteur (102) ; et
une structure d'isolation galvanique (128) comprenant :
une première couche diélectrique (110) disposée sur le substrat semi-conducteur (102), la première couche diélectrique (110) comprenant une ou plusieurs cavités d'air (118) ; et
une première structure conductrice (116) formée sur la couche diélectrique, la structure conductrice (116) ayant une surface inférieure qui fait face au substrat semi-conducteur (102), où les cavités d'air respectives des une ou plusieurs cavités d'air (118) de la première couche diélectrique (110) sont chacune disposées directement entre les coins de la surface inférieure de la structure conductrice (116) et du substrat semi-conducteur (102) ; où la structure d'isolation (128) comprend en outre :
une deuxième structure conductrice (106) disposée directement sur le substrat semi-conducteur (102), la deuxième structure conductrice (106) étant couplée capacitivement à la première structure conductrice (116), et les une ou plusieurs cavités d'air (118) étant disposées de manière à réduire l'intensité du champ électrique entre les coins de la surface inférieure de la structure conductrice (116) et de la deuxième structure conductrice (106).

2. Dispositif à semi-conducteur (100) selon la revendication 1, comprenant en outre :
une troisième structure conductrice (114) disposée directement sur le substrat semi-conducteur (102) ;
une quatrième structure conductrice (104) disposée au moins partiellement sur la première couche diélectrique (110), où la quatrième structure conductrice (104) et la première structure conductrice (116) sont formées dans la même couche ; et
un trou d'interconnexion conducteur (112) qui s'étend à travers la première couche diélectrique (110) entre la première structure conductrice (116) et la troisième structure conductrice (114), de sorte que le trou d'interconnexion conducteur (112) relie électriquement la quatrième structure conductrice (104) à la troisième structure conductrice (114).

3. Dispositif à semi-conducteur (100) selon la revendication 1 ou la revendication 2, comprenant en outre :
une deuxième couche diélectrique (120) disposée sur la première structure conductrice (116) et la première couche diélectrique (110).

4. Dispositif à semi-conducteur (100) selon la revendication 3, dans lequel la deuxième couche diélectrique (120) comprend une ouverture qui recouvre la première structure conductrice (116), de sorte qu'une surface supérieure de la première structure conductrice (116) soit exposée à travers l'ouverture.

5. Dispositif à semi-conducteur (100) selon l'une quelconque des revendications précédentes, dans lequel les une ou plusieurs cavités d'air (118) dans la première couche diélectrique (110) sont disposées directement entre les bords de la surface inférieure de la première structure conductrice (116) et le substrat semi-conducteur (102), de sorte que les une ou plusieurs cavités d'air chevauchent un périmètre de la surface inférieure de la première structure conductrice (116).

6. Dispositif à semi-conducteur (100) selon l'une quelconque des revendications précédentes, dans lequel les une ou plusieurs cavités d'air (118) dans la première couche diélectrique (110) sont disposées uniquement aux coins de la surface inférieure de la première structure conductrice (116).

7. Dispositif à semi-conducteur (100) selon l'une quelconque des revendications précédentes, comprenant en outre :
un matériau d'oxyde disposé sur une ou plusieurs surfaces de la première structure conductrice (116) au niveau des coins de la première structure conductrice (116), de sorte que le matériau d'oxyde sépare les coins de la première structure conductrice (116) des une ou plusieurs cavités d'air (118) dans la première couche diélectrique (110).

8. Dispositif à semi-conducteur (100) selon l'une quelconque des revendications précédentes, comprenant en outre :
une deuxième couche diélectrique (120) disposée sur la première couche diélectrique (110) et la première structure conductrice (116), la deuxième couche diélectrique (120) comprenant au moins une ouverture à travers laquelle une surface supérieure de la première structure conductrice (116) est exposée.

9. Procédé de fabrication d'un dispositif à semi-conducteur (100), le procédé comprenant les étapes suivantes :
fournir un substrat (102) ;
former une première couche conductrice à motifs sur le substrat (102), la première couche conductrice à motifs comprenant une première plaque de condensateur (116) ;
former une première couche diélectrique (110) sur la première couche conductrice à motifs ;
former une deuxième couche conductrice à motifs sur la première couche diélectrique (110), la deuxième couche conductrice à motifs comprenant une deuxième plaque de condensateur (106) ;
former une couche de photorésine à motifs sur le substrat (102), la couche de photorésine à motif comprenant des ouvertures au niveau d'un ou de plusieurs bords de la deuxième plaque de condensateur (106) ; et
graver des parties de la première couche diélectrique (110) à travers les ouvertures de la couche de photorésine à motifs pour former des cavités d'air (118) au niveau des bords de la deuxième plaque de condensateur (106).

10. Procédé selon la revendication 9, dans lequel la gravure des parties de la première couche diélectrique (110) à travers les ouvertures dans la couche de photorésine à motifs pour former des cavités d'air au niveau des bords de la deuxième plaque de condensateur (106) comprend l'étape suivante :
graver les parties de la première couche diélectrique (110) à travers les ouvertures de la couche de photorésine à motifs pour former des espaces d'air au niveau des bords de la deuxième plaque de condensateur (106).

11. Procédé selon la revendication 9 ou la revendication 10, dans lequel la première couche conductrice à motifs comprend en outre une première structure conductrice (114), et la deuxième couche conductrice à motifs comprend en outre une deuxième structure conductrice (104) et un trou d'interconnexion conducteur (112) qui couple électriquement la première structure conductrice (114) à la deuxième structure conductrice (104).

12. Procédé selon la revendication 11, comprenant en outre l'étape suivante :
réaliser une gravure structurée de la première couche diélectrique (110) pour former une ouverture dans la première couche diélectrique (110), le trou d'interconnexion conducteur (112) étant ensuite formé dans l'ouverture de la première couche diélectrique (110).

13. Procédé selon l'une quelconque des revendications 9 à 12, comprenant en outre l'étape suivante :
après avoir formé les cavités d'air (118) au niveau des bords de la deuxième plaque de condensateur (106), attaquer par gravure les parties exposées de la deuxième plaque de condensateur (106).

14. Procédé selon la revendication 13, dans lequel la gravure des parties exposées de la deuxième plaque de condensateur (106) provoque l'arrondi des bords et des coins de la deuxième plaque de condensateur (106).
